# NEUE EUROPÄISCHE PATENTSCHRIFT

(11) **EP 1 061 783 B2**
(45) Veröffentlichungstag und Bekanntmachung des Hinweises auf die Entscheidung über den Einspruch: **25.12.2019**
(45) Hinweis auf die Patenterteilung: 20.11.2013
(21) Anmeldenummer: 00112228.2
(22) Anmeldetag: 07.06.2000
(51) Int. Cl.: H01L 21/48, H01L 23/498, H05K 1/02, H01L 23/373

(54) **Keramik-Metall-Substrat, insbesondere Mehrfachsubstrat**
Ceramic-metal substrate, particularly multiple substrate
Substrat céramique-métal, notamment substrat multiple

(30) Priorität: 14.06.1999 DE 19927046
(43) Veröffentlichungstag der Anmeldung: 20.12.2000
(73) Patentinhaber: Rogers Germany GmbH, 92676 Eschenbach (DE)
(72) Erfinder: Dr.-Ing. Jürgen Schulz-Harder, 91207 Lauf (DE)
(74) Vertreter: Kaufmann, Tobias

(56) Entgegenhaltungen:
- EP-A- 0 827 198
- EP-A- 0 966 186
- EP-A2- 0 632 681
- DE-A1- 4 318 241
- DE-A1- 4 319 944
- DE-C1- 4 004 844
- JP-A- H01 278 086
- Renbi, A. et al: "Impact of etch factor on characteristic imped- ance, crosstalk and board quality", IMAPS 2012,
- Jilik, W. et al: Handbuch der Leiterplattentechnik, Band 4, 2003, pages 717-755,
- "Warum DCB-Substrate?", Curamik Electronics, 2001,
- Pönike, A. et al: "Aktivlöten von Kupfer mit Aluminiumnitrid- und Siliziumnitridkeramik", Keramische Zeitschrift, May 2011 (2011-05),

## Beschreibung

Die Erfindung bezieht sich auf ein Keramik-Metall-Substrat gemäß Oberbegriff Patentanspruch 1.

Bekannt sind Keramik-Metall-Substrate und dabei insbesondere auch Keramik-Kupfer-Substrate. Diese Substrate werden zum Herstellen von elektrischen Schaltkreisen, insbesondere Leistungsschaltkreisen verwendet und bilden die dortigen "Leiterplatten".

Im einfachsten Fall weisen derartige Substrate eine Keramikschicht auf, die an beiden Oberflächenseiten jeweils mit einer Metallisierung versehen ist, von denen z.B. die Metallisierung an der Oberseite der Keramikschicht beispielsweise unter Anwendung einer Ätztechnik derart strukturiert wird, dass diese Metallisierung dann die für den Schaltkreis erforderlichen Leiterbahnen, Kontaktflächen usw. bildet.

Für eine rationelle Fertigung von elektrischen Schaltkreisen ist es ein Mehrfachsubstrat bekannt (DE-PS 43 19 944) bekannt, bei dem auf einer großformatigen Keramikplatte oder -schicht wenigstens zwei aneinander anschließende und einstückig miteinander verbundene Einzelsubstrate gebildet sind, welche jeweils an wenigstens einer Oberflächenseite der Keramikschicht mit wenigstens einer Metallfläche versehen sind und jeweils über wenigstens eine in der Keramikschicht vorgesehene Sollbruchlinie aneinander anschließen. An diesen Sollbruchlinien erfolgt das Zertrennen des Mehrfachsubstrates in die Einzelsubstrate beispielsweise auch nach dem Bestücken mit den Bauelementen, und zwar durch Brechen. Nachteilig hierbei ist, dass es bedingt durch innere Spannungen im Keramik-Metall-Substrat, die aus den Temperaturen beim Aufbringen der Metallisierungen und die unterschiedlichen thermischen Ausdehnungskoeffizienten resultieren, zu unkontrollierten Brüchen Trennen oder Brechen kommen kann. Obwohl derartige unkontrollierbare Brüche nur in 1 bis 5% der Fälle auftreten, ist der hiermit verbundene Produktionsausfall und Schaden nicht unerheblich, insbesondere wenn das Zertrennen in die Einzelsubstrate erst nach deren Bestückung erfolgt.

Das Aufbringen der Metallisierungen erfolgt in Heißverfahren, d.h. in Verfahren, in denen nicht unerhebliche Temperaturen zu Anwendung kommen. So ist beispielsweise bekannt, die für Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1065 bis 1083°C, z.B. auf ca. 1071 °C;
- Abkühlen auf Raumtemperatur.

Bekannt sind weiterhin Metall-Keramik-Substrate (EP 0 827 198 A2) bestehend aus einer Keramikschicht, die an ihren Oberflächenseiten mit Hilfe des DCB-Verfahrens oder des Aktiv-Lot-Verfahrens mit jeweils einer Metallschicht versehen ist, von denen die Metallschicht an einer Oberflächenseite der Keramikschicht eine größere Dicke aufweist als die Metallschicht an der anderen Oberflächenseite der Keramikschicht. Zur Verbesserung der thermischen Eigenschaften ist zumindest die Metallplatte größerer Dicke an ihrem Umfang mit einem abgestuften Randbereich versehen.

Aufgabe der Erfindung ist es, ein als Mehrfachsubstrat ausgebildetes Keramik-Metall-Substrat aufzuzeigen, welches ohne die Gefahr von unkontrollierten Brüchen durch Brechen entlang der Sollbruchlinien in Einzelsubstrate getrennt werden kann. Zur Lösung dieser Aufgabe ist ein Keramik-Metall-Substrat entsprechend dem Patentanspruch 1 ausgebildet.

Durch die erfindungsgemäße Ausbildung werden in überraschender Weise unkontrollierte Brüche beim Zertrennen des Keramik-Metall-Substrates wesentlich reduziert (nachgewiesener Maßen bis 75%).

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in vereinfachter Darstellung und in Draufsicht ein Keramik-Metall-Substrat in Form eines Mehrfachsubstrates gemäß der Erfindung im unbestückten Zustand;
- Fig. 2: in vereinfachter Darstellung und in Unteransicht das Mehrfachsubstrat gemäß Fig. 1;
- Fig. 3: einen Schnitt entsprechend der Linie I - I der Figur 1;
- Fig. 4: eine vergrößerte Teildarstellung der Rückansicht des Mehrfach-Substrates der Figur 1;
- Fig. 5: ein Teilschnitt durch das Mehrfach-Substrat gemäß einem nicht erfindungsgemäßen Beispiel;
- Fig. 6: in vergrößerter Teildarstellung eine Ansicht der Unterseite des Mehrfach-Substrates der Figur 1 im Bereich eines Einzel-Substrates bei einer weiteren möglichen Ausführungsform;
- Fig. 7: einen Teilschnitt entsprechend der Linie II - II der Figur 6;
- Fig. 8, und 9: jeweils in vergrößerter Teildarstellung eine Ansicht der Unterseite des Mehrfach-Substrates bei einer weiteren Ausführungsform;
- Fig. 10: in vergrößerter Teildarstellung eine Ansicht der Unterseite des Mehrfach-Substrates gemäß einem nicht erfindungsgemäßen Beispiel,
- Fig. 11: einen Schnitt entsprechend der Linie III - III der Figur 10;
- Fig. 12: in Darstellung ähnlich Figur 6 eine weitere mögliche Ausführungsform;
- Fig. 13: einen Schnitt entsprechend der Linie IV - IV der Figur 12;
- Fig. 14: in vereinfachter Darstellung eine Unteransicht eines Mehrfach-Substrates einer weiteren Ausführungsform der Erfindung;
- Fig. 15: einen Schnitt durch das Mehrfach-Substrat der Figur 14 entsprechend der Linie V - V der Figur 14;
- Fig. 16: eine Draufsicht auf ein bestücktes Mehrfach-Substrat;
- Fig. 17: eine weitere mögliche Ausführungsform in einer Darstellung ähnlich Fig. 2.

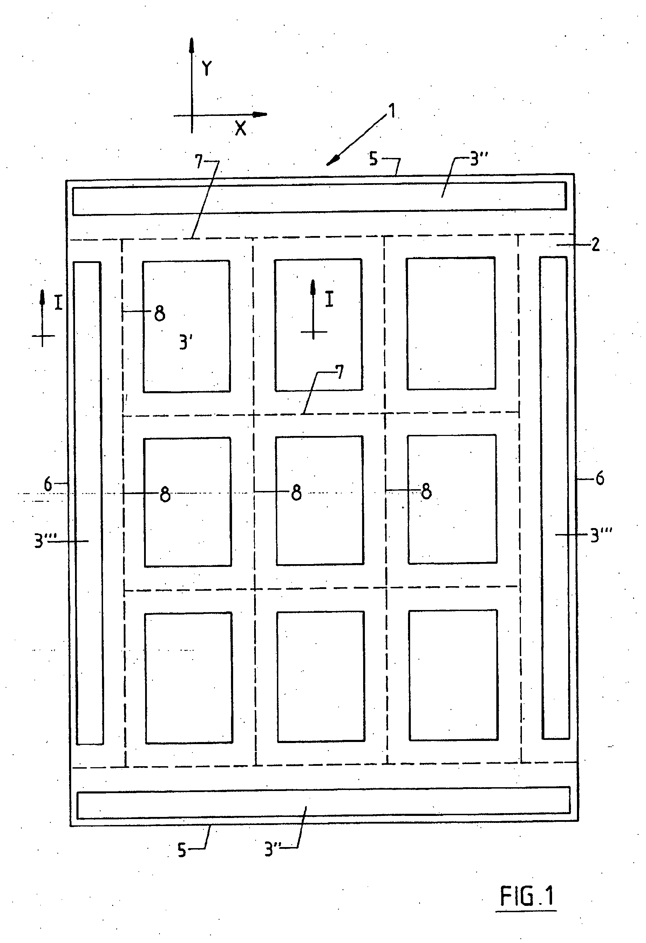

Zur einfacheren Erläuterung sind in den Figuren 1 - 13 jeweils drei senkrecht zueinander angeordnete Raumachsen (X-Achse, Y-Achse und Z-Achse) angegeben, von denen die X- und Y-Achsen die Ebene des jeweiligen Mehrfachsubstrates definieren (X-Y-Ebene) und die Z-Achse in Richtung der Dicke des jeweiligen Mehrfachsubstrates liegt.

Das in den Figuren 1 - 4 dargestellte und allgemein mit 1 bezeichnete Mehrfach-Substrat (auch Großkarte) besteht im wesentlichen aus einer Keramikplatte oder Keramikschicht 2, die beispielsweise eine Aluminiumnitrid-Keramik oder eine Aluminiumoxid-Keramik ist und bei der Ausführungsform der Figuren 1 - 3 an beiden Oberflächenseiten mit einer strukturierten Metallisierung versehen ist, und zwar an der Oberseite mit der Metallisierung 3 und an der Unterseite mit der Metallisierung 4. Bei den Metallisierungen sind bei der dargestellten Ausführungsform dadurch realisiert, dass mit Hilfe der DCB-Technik jeweils eine Metallfolie, beispielsweise eine Kupferfolie flächig mit der Keramikschicht 2 verbunden ist. Die Strukturierung der Metallisierungen 3 und 4 ist mit den üblichen, den Fachmann bekannten Mitteln durchgeführt, beispielsweise unter Verwendung von Maskierungs- und Ätztechniken.

Bei dem Mehrfachsubstrat 1 ist die Metallisierung 3 an der Oberseite so strukturiert, dass diese mehrere Metallflächen 3' bildet, die in mehreren, sich jeweils in Richtung der X-Achse erstreckenden und in Richtung der Y-Achse aneinander anschließenden Reihen vorgesehen sind.

Das Mehrfachsubstrat 1 ist bei der dargestellten Ausführungsform mit einer rechteckförmigen Umfangslinie ausgebildet, und zwar derart, dass die kürzeren Umfangsseiten sich in Richtung der X-Achse und die längeren Umfangsachsen in Richtung der Y-Achse erstrecken.

Die Metallisierung 3 ist weiterhin so strukturiert, dass sie entlang der Ränder 5 und 6 jeweils eine rechteck- oder streifenförmige Metallfläche 3" (entlang der Ränder 5) sowie 3"' (entlang der Ränder 6) bildet, wobei sich die beiden Metallflächen 3" jeweils im wesentlichen über die gesamte Breite (Abstand der beiden Ränder 6) des Mehrfachsubstrates 1 erstrecken und die beiden Metallflächen 3" an beiden Enden jeweils in der Nähe einer Metallfläche (3") enden.

Die Metallfläche 3' liegen mit ihren Rändern parallel zu den Rändern 5 und 6 und damit ebenfalls in der X-Achse bzw. Y-Achse. Ebenso liegen die streifenförmigen bzw. langgestreckt rechteckförmigen Metallflächen 3" und 3"' mit ihren Rändern parallel zu den Rändern 5 und 6 und damit in Richtung der X-Achse bzw. Y-Achse.

Sämtliche Metall-Flächen 3', 3", 3"' sind jeweils von einer benachbarten Metallfläche beabstandet, wie dies nachstehend noch näher erörtert wird. In den zwischen den Metallflächen 3', 3" und 3"' frei liegenden Bereichen der Keramikschicht 2 sind in diese Sollbruchlinien 7 und 8 bildende Ritzungen eingebracht, und zwar derart, dass diese Sollbruchlinien sich nicht nur zwischen den einzelnen, die Einzelsubstrate bildenden Metallflächen 3' erstrecken, sondern auch zwischen den Metallflächen 3" und angrenzenden Metallflächen 3' und 3"' sowie zwischen den Metallflächen 3"' und angrenzenden Metallflächen 3'. Im einzelnen erstrecken sich die Sollbruchlinie 7 in Richtung der X-Achse und die Sollbruchlinien 8 in Richtung der Y-Achse, wobei jeweils eine außen liegende Sollbruchlinie 7, die der Metallfläche 3" benachbart ist, sich bei der dargestellten Ausführungsform über die gesamte Breite des Mehrfachsubstrates 1 erstreckt, d.h. auch in den frei liegenden Bereichen der Oberseite der Keramikschicht 2 zwischen den Metallisierungen 3" und 3"'. Die beiden außen liegenden Sollbruchlinien 8 erstrecken sich jeweils zwischen der jeweiligen Metallfläche 3"' und den angrenzenden Metallflächen 3' und enden bei der dargestellten Ausführungsform jeweils an den Metallflächen 3" bzw. an den parallel zu diesen Metallflächen verlaufenden äußeren Sollbruchlinien 7.

Die Metallisierung 4 an der Unterseite des Mehrfachsubstrates 1 ist so strukturiert, dass diese Metallisierung eine Vielzahl von Metallflächen 4' bildet, die den Metallflächen 3' entsprechen und von denen jeweils eine Metallfläche 4' einer Metallfläche 3' unmittelbar gegenüberliegt. Auch die Metallflächen 4' sind in gleicher Weise wie die Metallflächen 3' in mehreren Reihen vorgesehen und liegen mit ihren Rändern parallel zu den Rändern 5 und 6. Weiterhin bildet die Metallisierung 4 Metallflächen 4" und 4"', die den Metallflächen 3" bzw. 3"' entsprechen und von denen jede Metallfläche 4" einer Metallfläche 3" und jede Metallfläche 4"' einer Metallfläche 3"' gegenüber liegt. Die Metallflächen 4', 4" und 4"' sind an den Sollbruchlinien 7 und 8 voneinander beabstandet, so dass dort die Unterseite der Keramikschicht 2 frei liegt.

Entlang der Sollbruchlinien 7 und 8 kann das Mehrfachsubstrat insbesondere nach dem Strukturieren der Metallflächen 3' und nach den Bestücken in Einzelsubstrate bzw. in von diesen Einzelsubstraten gebildete elektrische Bauteile durch Brechen entlang der Sollbruchlinien 7 und 8 zertrennt werden, wobei hierfür zunächst ein Öffnen des Mehrfachsubstrates 1 dadurch notwendig ist, dass die mit den Metallflächen 3" und 3"' sowie 4" und 4"' versehenen Ränder abgebrochen werden, und zwar entlang der äußeren Sollbruchlinien 7 bzw. 8. Dieses Öffnen ist nur in einer bestimmten Reihenfolgen möglich, nämlich dadurch, dass zunächst die die Metallflächen 3" und 4" aufweisenden äußeren Ränder und dann die die Metallflächen 3"' uns 4"' aufweisenden äußeren Ränder abgebrochen werden. Durch die Metallflächen 3", 4" und 3"', 4"', die insbesondere auch die zwischen den Metallflächen 3' verlaufenden Sollbruchlinie 7 und 8 überbrücken, ist ein nicht beabsichtigtes Brechen des Mehrfachsubstrates 1 wirksam verhindert.

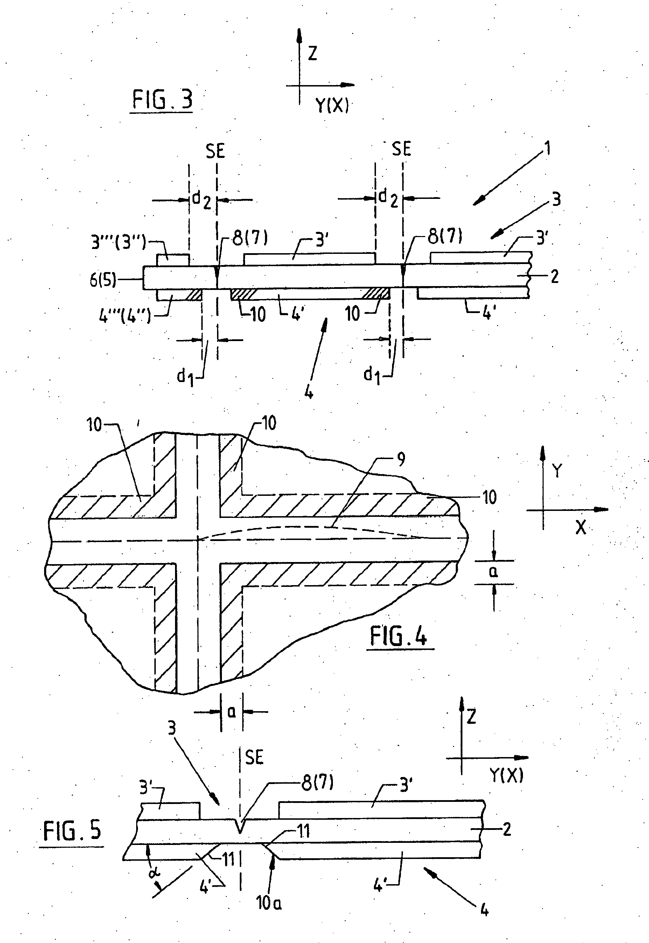

Die Figur 3 zeigt einen Teilschnitt durch das Mehrfachsubstrat der Figur 1. Mit SE sind in dieser Figur die senkrecht zur XY-Ebene verlaufenden Ebenen bezeichnet, die die Sollbruchlinien 7 bzw. 8 einschließen. Wie in der Figur 3 dargestellt ist, besitzen sämtliche Metallflächen 4' von diesen Mittelebenen SE jeweils einen Abstand d1. Die Ränder sämtlicher Metallflächen 3', 3" und 3"' besitzen von der parallel zu dem jeweiligen Rand verlaufenden, benachbarten Ebene SE einen abstand von d2. Dies gilt sowohl für die parallel zur XZ-Ebene als auch für die parallel zur YZ-Ebene angeordneten Ebenen SE.

Bei der dargestellten Ausführungsform beträgt die Dicke der Metallisierung 3 und 4 beispielsweise 0,15 - 1,0 mm. Weiterhin gilt bei dem Mehrfachsubstrat 1, dass der jeweilige Abstand d2 größer oder gleich d1 ist, wobei z.B. d1 in der Größenordnung von 1,0 bis 0,05 mm liegt. Bei dem Mehrfachsubstrat 1 sind die Abstände d2 größer als 1 mm.

Die Sollbruchlinien 7 und 8 sind beispielsweise durch eine Laserbehandlung, beispielsweise durch Laser-Ritzen erzeugt. Die Sollbruchlinien 7 und 8 können aber auch auf andere Weise, beispielsweise durch mechanische Bearbeitung erzeugt sein.

Bei dem Aufbringen der Metallisierungen 3 und 4 auf die Keramikschicht 2 entstehend bedingt durch die hohen Prozesstemperaturen und die unterschiedlichen Wärmeausdehnungskoeffizienten des Keramikmaterials und des Metalls der Metallisierungen im Substrat mechanische Spannungen, die dann bei der Strukturierung der Metallisierungen 3 und 4 bzw. bei der Strukturierung der Metallflächen 3' partiell gelöst werden, womit mechanische Restspannungen im Mehrfachsubstrat verbleiben, deren Orientierung und Größe nicht kontrollierbar ist.

Beim Vereinzeln des Mehrfachsubstrates in Einzelsubstrate durch Brechen entlang der Sollbruchlinien 7 und 8 kann es daher dazu kommen, dass in ungünstigen Fällen sich eine im Mehrfach-Substrat vorhandene, partielle Restspannung zu den beim Brechen auftretenden Kräften oder Spannungen so addiert, dass das Brechen nicht in der gewünschten Weise entlang der betreffenden Sollbruchlinie 7 bzw. 8 erfolgt, sondern entlang einer hiervon abweichenden wilden Bruchlinie, die in der Figur 4 mit der unterbrochenen Linie 9 angegeben ist.

Insbesondere dann, wenn das Vereinzeln des Mehrfachsubstrates erst nach dem Bestücken mit Bauelementen erfolgt, bedingen derartige unkontrollierte Brüche 9 erhebliche Schäden, da die entsprechenden Einzelsubstrate dann nicht mehr brauchbar sind. Der Schaden ist hierbei nicht nur durch die Kosten des Einzelsubstrates, sondern insbesondere auch durch die Arbeits- und Maschinenkosten bei der Bestückung und die Kosten der Bauelemente, mit denen ein derartiges schadhaftes Einzelsubstrat bestückt ist, bestimmt. Als Faustregel gilt, dass der Wert eines bestückten Einzelsubstrates etwa dem 10-Fachen eines unbestückten Einzelsubstrates entspricht.

Um derartige unkontrollierte Brücke 9 zu vermeiden und um dennoch die Abstände d1 möglichst klein zu halten, so dass die an der Unterseite des jeweiligen Einzelsubstrates vorgesehenen Metallfläche 4' möglichst dicht bis an den Rand dieses Einzelsubstrates reicht, wie dies allgemein aus verschiedensten Gründen gefordert wird, sind die Metallflächen 4' an der Unterseite entlang ihrer Ränder mit einer Abschwächung (Kanten- oder Randabschwächung) versehen, die in der Figur 3 allgemein mit 10 bezeichnet ist.

Diese Randabschwächung 10 kann, wie nachstehend noch näher ausgeführt wird, in unterschiedlicher Weise realisiert sein, ist aber in jedem Fall so ausgebildet, dass im Bereich dieser Randabschwächung 10 das Metall-Volumen bzw. die Metallmenge je Volumeneinheit reduziert ist. Die Breite der Randabschwächung ist in der Figur 4 mit a bezeichnet und liegt in der Größenordnung zwischen 0,2 und 6 mm. Die Reduzierung der Metallmenge bzw. des Metallvolumens, ist derart, dass an der Randabschwächung 10 die Metallmenge nur 10 bis 80% der Metallmenge einer Metallfläche 4' ohne Randabschwächung beträgt, und zwar jeweils bezogen auf eine bestimmte Volumeneinheit. Die Randabschwächung 10 ist auch an den Metallflächen 4" und 4"' vorgesehen, und zwar entlang der den Sollbruchlinien 7 und 8 benachbarten Kanten, d.h. entlang der Ebenen SE.

Es hat sich gezeigt, dass es durch diese Randabschwächung 10 möglich ist, die Metallflächen 4' mit dem nur geringen Abstand d1 von den Ebenen SE vorzusehen und dennoch unkontrollierte Brüche 9 stark zu reduzieren, so dass insgesamt eine Reduzierung des Ausschusses gegenüber herkömmlichen Mehrfach-Substraten um 75% nachweisbar ist. Den Randabschwächungen 10 entsprechende Randabschwächungen an den Metallflächen 3', 3" und 3"' sind dann notwendig oder zumindest sinnvoll, wenn die Abstände d2 kleiner als 1 mm sind.

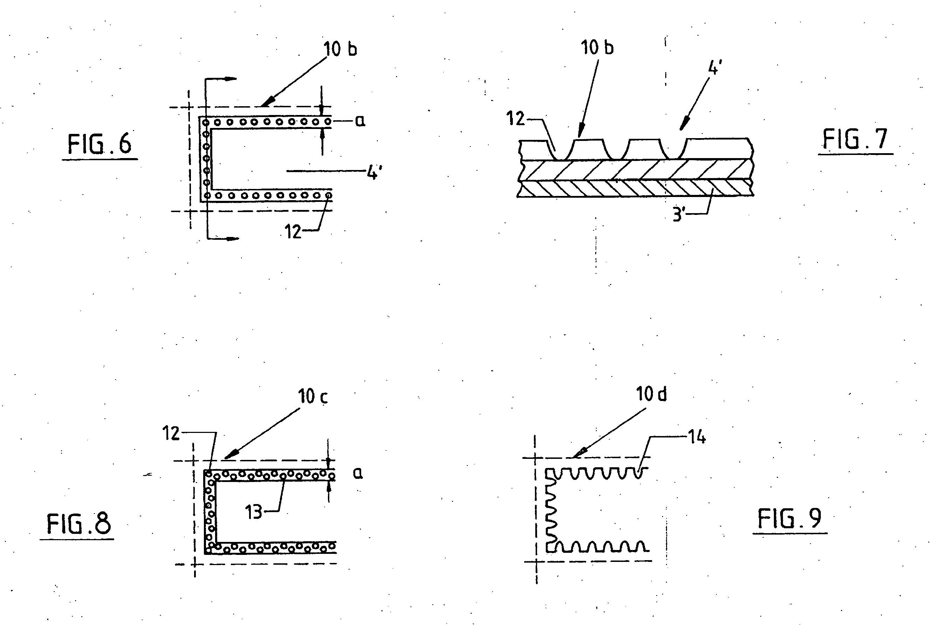

Die Figuren 6 - 15 zeigen als Beispiele verschiedene Möglichkeiten für die Ausbildung der Randabschwächung 10. In der Figur 5 ist ein nicht erfindungsgemäßes Beispiel einer Randabschwächung 10a dargestellt, die dadurch gebildet ist, dass die den Ebenen SE benachbarten Ränder der Metallflächen 4', 4", 4'" abgeschrägt sind, wobei die hierbei gebildete schräge Randfläche 11 beispielsweise in einem Winkel α, der kleiner als 45° beträgt.

Die Figuren 6 und 7 zeigen eine Randabschwächung 10b, die dadurch gebildet ist, dass entlang der den Ebenen SE benachbarten Ränder der Metallflächen 4', 4", 4"' Reihen von lochartigen Vertiefungen 12 gebildet sind, wobei diese Vertiefungen 12 bis an die Unterseite der Keramikschicht 2 reichen und beispielsweise einen Durchmesser von etwa 0,4 bis 0,5 mm aufweisen. Die Vertiefungen 12 bilden bei dieser Ausführungsform eine einfache Lochreihe. Bei einer möglichen Ausführungsform besitzen die Vertiefungen 12 einen Durchmesser von etwa 0,5 mm. Die Breite a der Randabschwächung 10b, innerhalb der (Breite) sich auch die Vertiefungen 12 befinden, beträgt beispielsweise 0,8 mm, und zwar bei einem Abstand d1 von etwa 0,5 mm. Die Breite a ist hierbei so definiert, dass a der maximale Abstand ist, den die Ränder der Vertiefungen 12 von dem benachbarten Rand der Metallisierung aufweisen.

Die Figur 8 zeigt eine mögliche Ausführungsform, bei der die Randabschwächung 10c von der äußeren, d.h. den Rändern der jeweiligen Metallisierung 4', 4", 4'" unmittelbar benachbarten Vertiefungen 12 und weiteren innen liegenden Vertiefungen 13 gebildet ist. Letztere sind jeweils gegenüber den Vertiefungen 12 auf Lücke versetzt und bilden zusätzlich zu der äußeren Lochreihe (Vertiefungen 12) eine innere Lochreihe (Vertiefungen 13), wobei sowohl die Vertiefungen 12 auch die Vertiefungen 13 bis an die Unterseite der Keramikschicht 2 reichen. Der Durchmesser der Vertiefungen 13 ist bei dieser Ausführungsform kleiner als der Durchmesser der Vertiefungen 12. Beispielsweise beträgt die Breite a der Randabschwächung 10c, innerhalb der (Breite a) sich sämtliche Vertiefungen 12 und 13 befinden, etwa 1,4 mm, wobei der Durchmesser der äußeren Vertiefungen etwa 0,6 mm und der inneren Vertiefungen etwa 0,4 mm beträgt. Die Breite a ist hierbei so definiert, dass a der maximale Abstand ist, den die Ränder der Vertiefungen 13 von dem benachbarten Rand der Metallisierung aufweisen.

Die Figur 9 zeigt als weitere Möglichkeit eine Randabschwächung 10d, die dadurch gebildet ist, dass die den Ebenen SE benachbarten Ränder oder Kanten der Metallflächen 4', 4" und 4"' mit zu diesen Rändern hin offenen Vertiefungen 14 versehen sind, so dass sich mäanderartig verlaufende Ränder ergeben. Die Vertiefungen 14 reichen wiederum bis an die Unterseite der Keramikschicht 2.

Grundsätzlich besteht bei den Randabschwächungen 10b - 10d auch die Möglichkeit, sämtliche oder aber nur einige der Vertiefungen 12, 13 bzw. 14 so auszuführen, dass diese nicht bis an die Unterseite der Keramikschicht 2 reichen, sondern noch ein den Boden der jeweiligen Vertiefung bildender Rest der Metallisierung 4 verbleibt.

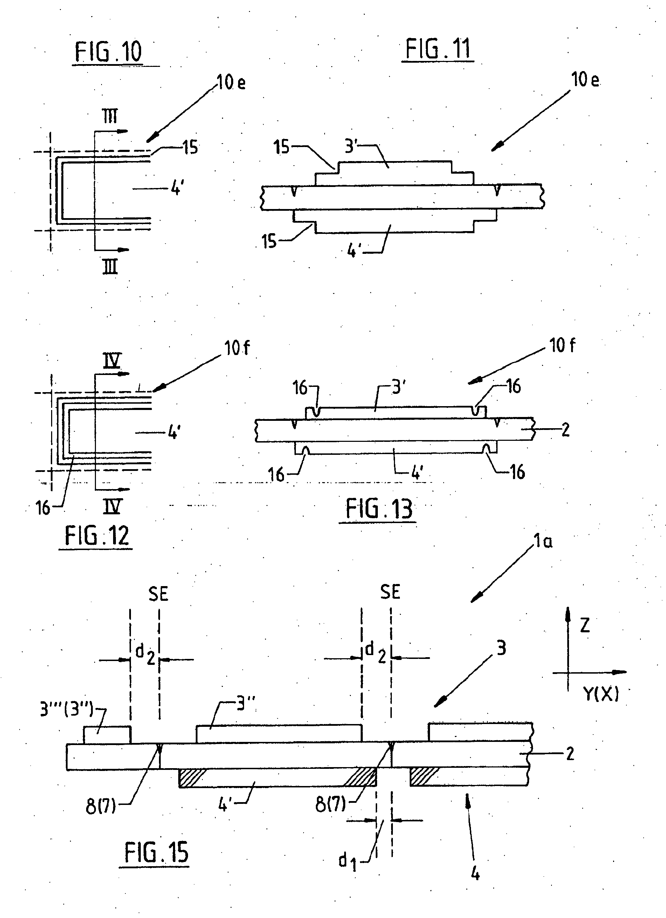

Die Figuren 10 und 11 zeigen als ein nichterfindungsgemäßes Beispiel eine Randabschwächung 10e, die durch eine Abstufung 15 der den Ebenen SE benachbarten Ränder der Metallflächen 4', 4", 4"' gebildet ist, d.h. innerhalb der Breite a der Randabschwächung 10e steigt die Dicke des Materials der jeweiligen Metallfläche stufenförmig an, und zwar bei der Ausführung der Figuren 9 und 10 in einer Stufe. Grundsätzlich können auch mehrere Stufen 15 vorgesehen sein.

Die Figuren 12 und 13 zeigen als weitere mögliche Ausführungsform eine Randabschwächung 10f, die dadurch gebildet ist, dass die Metallflächen 4', 4" und 4"' jeweils mit einer nutenartigen Vertiefung 16 versehen sind, die sich entlang der den Ebenen SE verlaufenden und in diesen Ebenen benachbarten Ränder der Metallflächen erstreckt, wobei die Vertiefung 16 an den Metallflächen 4' als in sich geschlossene Nut ausgeführt ist.

Um zu demonstrieren, dass es bei kleineren Abständen d2 zumindest zweckmäßig ist, auch die Metallflächen 3', 3" und 3"' an der Oberseite des Mehrfachsubstrates 1 mit einer entsprechenden Randabschwächung zu versehen, sind in den Figuren 10 - 13 Randabschwächungen 10e und 10f auch für die Metallflächen 3', 3" und 3"' dargestellt.

Es versteht sich, dass die einzelnen Randabschwächungen 10a - 10f auch kombiniert werden können, und zwar an jeweils einer Seite des Mehrfachsubstrates 1 oder aber an mehreren Seiten. Weiterhin versteht es sich, dass Randabschwächungen 10 selbstverständlich nur dort vorgesehen sind, wo auch entsprechende Metallflächen 3', 3", 3"' bzw. 4', 4", 4"' vorgesehen sind.

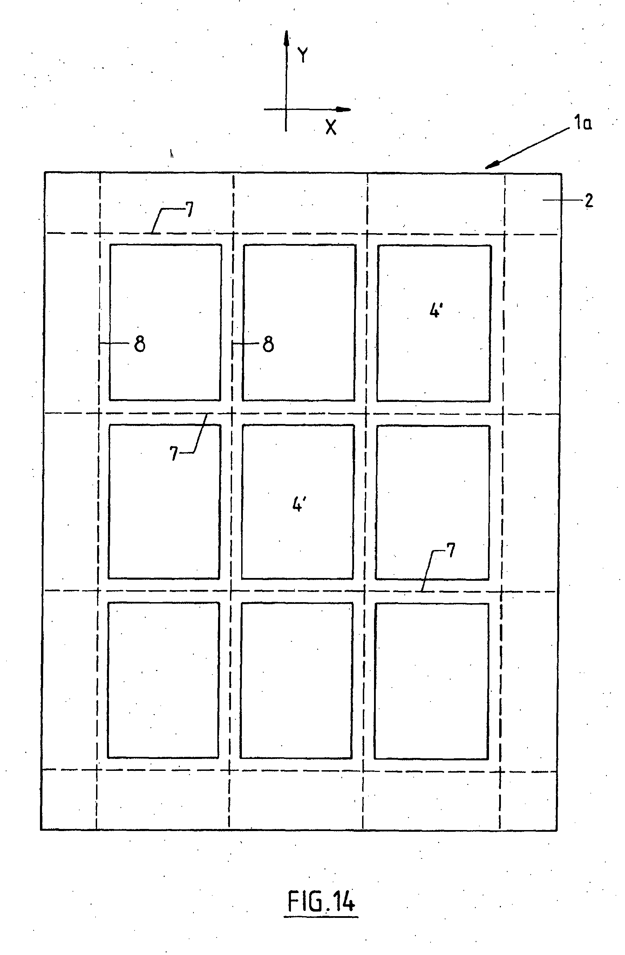

Die Figuren 14 und 15 zeigen in Darstellungen ähnlich den Figuren 1 und 3 als weitere mögliche Ausführungsform ein Mehrfachsubstrat 1a, welches sich von dem Mehrfachsubstrat 1 im wesentlichen nur dadurch unterscheidet, dass die an den Rändern 5 und 6 vorgesehenen Metallflächen 4" und 4"' nicht vorhanden sind, sondern lediglich die Metallflächen 3" und 3"' an der Oberseite des Mehrfachsubstrates.

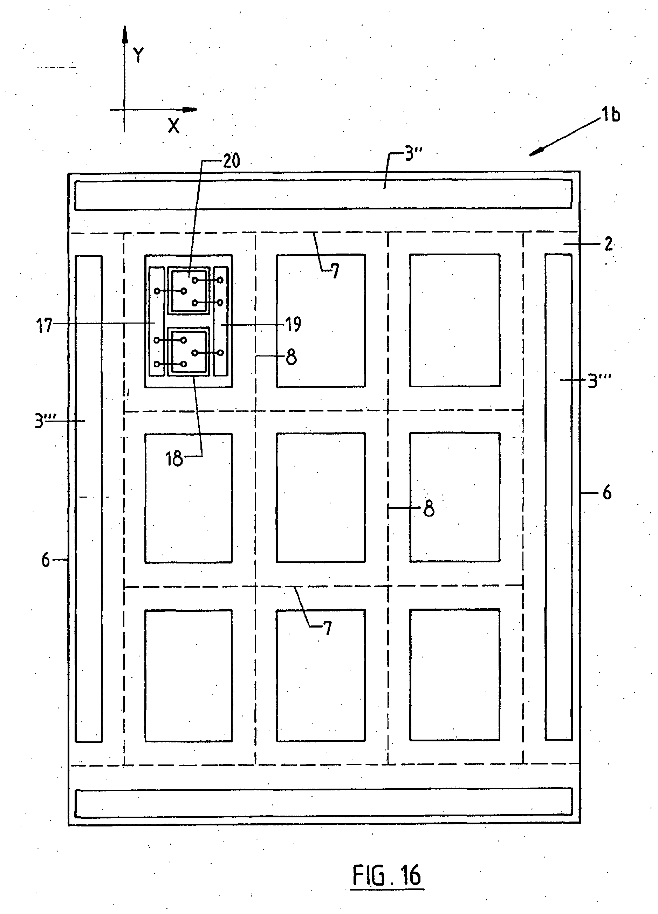

Die Figur 16 zeigt ein Mehrfachsubstrat 1b, welches beispielsweise den Mehrfachsubstrat 1 oder 1a entspricht, bei dem allerdings die an der Oberseite vorgesehen Metallflächen 3' zur Bildung von Leiterbahnen, Kontaktflächen usw. für die Einzelsubstrate strukturiert sind, wie dies in dieser Figur mit den Ziffern 17, 18 und 19 schematisch angegeben ist. Auf den strukturierten Flächenbereichen 18 sind Bauelemente in Form von Halbleiterchips 20 aufgebracht, die mit den zugehörigen, elektrische Kontaktflächen bzw. Anschlüsse bildenden strukturierten Bereichen 17 und 18 durch Drahtbonds elektrisch verbunden sind. Obwohl nur für ein Einzelsubstrat bzw. eine Metallfläche 3' dargestellt, sind sämtliche Metallflächen 3' in dieser Weise strukturiert und mit Bauelementen bestückt, so dass hierdurch eine Großkarte oder eine Mehrfach-Leiter-Platte bzw. ein bestücktes Mehrfachsubstrat erhalten ist, welches erst nach dem Bestücken in die Einzelsubstrate bzw. in die einzelnen von diesen gebildeten Baugruppen oder Schaltkreise zertrennt wird.

Bei den vorstehend beschriebenen Ausführungsbeispielen war eine Randabschwächung 10 an den Metallflächen 4', 4" bzw. 4"' (selbstverständlich nur soweit diese Metallflächen vorhanden) sowie ggf. auch an den Metallflächen 3', 3" und 3"' entlang sämtliche, jeweils einer Ebene SE benachbarter Kanten oder Ränder vorgesehen.

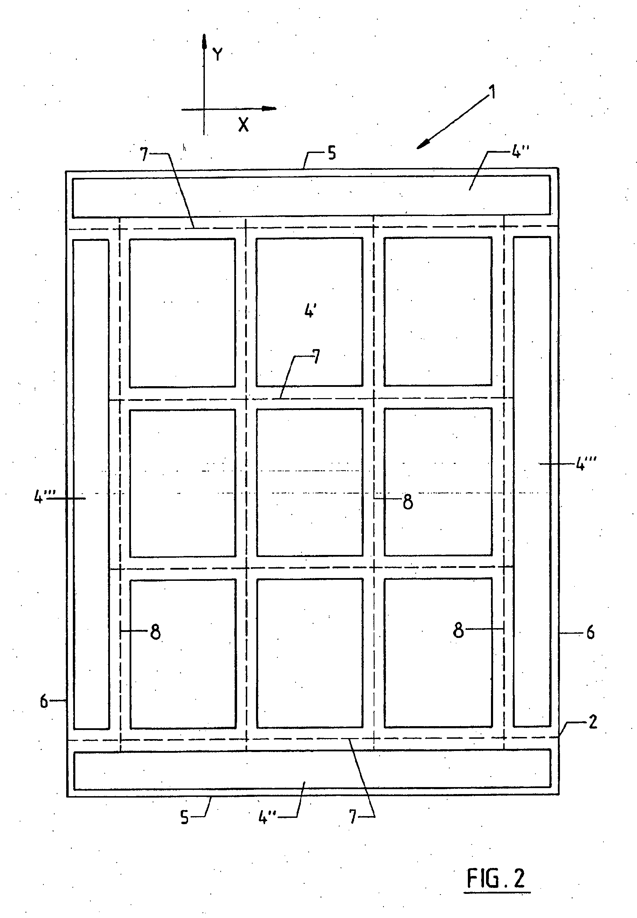

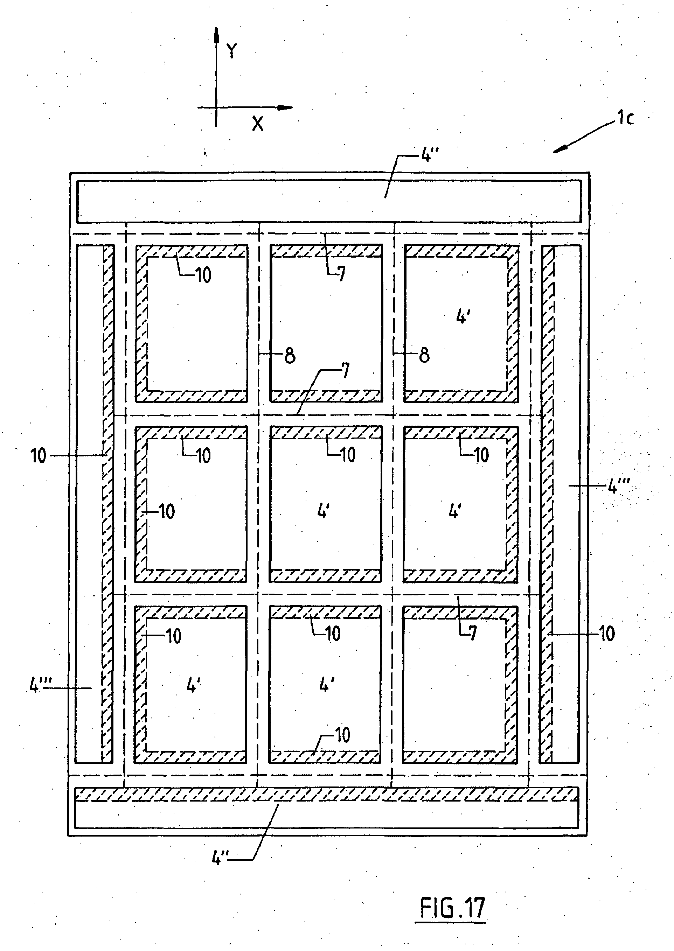

Die Figur 17 zeigt in einer Darstellung ähnlich der Figur 2 als weitere Möglichkeit ein Mehrfachsubstrat 1c, bei dem Rand- oder Randabschwächungen 10 nur entlang eines Teils der Ränder der Metallflächen 4', 4" bzw. 4"' und ggf. ebenso nur an einem Teil der Ränder der Metallflächen 3', 3" und 3"' vorgesehen sind, und zwar wiederum natürlich nur dann, wenn die betreffende Metallfläche tatsächlich vorhanden ist.

Der in der Figur 17 dargestellten Ausführungsform liegt die Erkenntnis zugrunde, dass wilde Brüche 9 bevorzugt dann auftreten, wenn beim Vereinzeln bzw. Brechen des Mehrfachsubstrates in Einzelsubstrate bei dem jeweiligen Brechvorgang entlang einer Sollbruchlinie 7 bzw. 8 gebrochen wird, die sich über mehrere Einzelsubstrate erstreckt. Erfolgt beispielsweise das Vereinzeln des Mehrfachsubstrates 1c nach der nachstehend angegebenen Regel oder Brechabfolge, so kann an denjenigen Rändern der Metallflächen 3', die den zwischen diesen Metallflächen 3' verlaufenden Sollbruchlinien 8 bzw. den Ebenen SE benachbart sind, die die zwischen den Metallflächen 4' verlaufenden Sollbruchlinie 8 einschließen, auf eine Randabschwächung 10 verzichtet werden. Gleiches gilt analog für die Metallflächen 3', sofern an diesen eine Randabschwächung notwendig oder sinnvoll ist.

In der Figur 17 sind die Ränder der Metallflächen 4', 4", 4"', die (Ränder) jeweils mit einer Randabschwächung 10 versehen sind, zusätzlich schraffiert. Die Ränder, die eine Randabschwächung 10 nicht aufweisen, sind als gerade Linie dargestellt. Wie der Figur 17 also zu entnehmen ist, sind die Metallflächen 4' jeweils an einem Rand, der einer Gruppe von zwischen diesen Metallflächen verlaufenden Sollbruchlinien, nämlich den in der Y-Achse verlaufenden Sollbruchlinien 8 benachbart sind, nicht mit der Randabschwächung 10 versehen, wohl aber an allen anderen Randbereichen.

Das Öffnen des Mehrfachsubstrates 1c und Brechen dieses Substrates in Einzelsubstrate erfolgt dann in folgender Abfolge:
1. Abbrechen der die Metallflächen 3" bzw. 4" aufweisenden Ränder;
2. Abbrechen der die Metallflächen 3"' bzw. 4"' aufweisenden Ränder;
3. Sukzessives Abbrechen der bei dieser Ausführungsform jeweils drei Einzelsubstrate aufweisenden und sich in der X-Achse erstreckenden Reihen oder Streifen entlang der Sollbruchlinien 7, und zwar beginnend beispielsweise von den in der Figur 17 oberen Rand des Mehrfachsubstrates 1c.
4. Brechen der einzelnen, so erhaltenen Streifen mit jeweils drei Einzelsubstraten entlang der in den einzelnen Streifen nur noch sehr kurzen Sollbruchlinien 8 in die Einzelsubstrate.

Da das Brechen der Streifen in die Einzelsubstrate gemäß vorstehender Ziffer 4 an Sollbruchlinien 8 erfolgt, deren Länge nur noch der Breite eines Einzelsubstrates entspricht, sind wilde Brüche 9 bei diesem Brechen wenig wahrscheinlich, so dass entlang der zwischen den Metallflächen 3' bzw. 4' verlaufenden Sollbruchlinien 8 auf eine Randabschwächung 10verzichtet werden kann.

Grundsätzlich besteht auch die Möglichkeit, die Brechabfolge zu ändern, d.h. nach dem Abbrechen der äußeren, die Metallflächen 3" bzw. 4" und 3"' bzw. 4"' aufweisende Ränder zunächst durch Brechen entlang der Sollbruchlinien 8 Streifen aus Einzelsubstraten herzustellen, die dann entlang der Sollbruchlinien 7 gebrochen werden. Bei dieser Brechabfolge sind dann auf jeden Fall Randabschwächungen 10 auch entlang der zwischen den Einzelsubstraten verlaufenden Sollbruchlinien 8 erforderlich, während auf Randabschwächungen entlang der zwischen den Einzelsubstraten verlaufenden Sollbruchlinien 7 verzichtet werden kann.

Allerdings gilt generell die Regel, dass das Brechen jeweils an möglichst kurzen Sollbruchlinien erfolgen soll, d.h. bei einer rechteckförmigen Ausbildung des Mehrfachsubstrates mit der größeren Länge in Richtung der Y-Achse und der kürzeren Breite in der X-Achse erfolgt zweckmäßig das Brechen in die Streifen entlang der kürzeren Sollbruchlinien 8.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird.

### Bezugszeichenliste

- 1, 1a, 1b, 1c: Mehrfach-Substrat
- 2: Keramikschicht
- 3, 4: Metallisierung
- 3', 3'', 3"': Metallfläche
- 4', 4'', 4"': Metallfläche
- 5, 6: Rand
- 7, 8: Sollbruchlinie
- 9: wilde Bruchlinie
- 10, 10a, 10b, 10c, 10d, 10e, 10f: Randabschwächung
- 11: Abschrägung oder schräge Randfläche
- 12, 13, 14: Vertiefung
- 15: Abstufung
- 16: Vertiefung
- 17, 18, 19: strukturierte Metallfläche
- 20: Bauelement

## Patentansprüche

1. Keramik-Metall-Substrat als Mehrfachsubstrat mit einer Keramikplatte oder -schicht (2), die wenigstens zwei aneinander anschließende und einstückig miteinander verbundene Substratbereiche bildet, welche jeweils an wenigstens einer Oberflächenseite der Keramikschicht (2) mit wenigstens einer Metallfläche (3', 3", 3"'; 4', 4", 4"') versehen sind, die durch Aufbringen einer Metallschicht oder Metallfolie mittels des DCB- oder Äktiv-Lot-Verfahrens erzeugt ist, und welche jeweils über wenigstens eine in der Keramikschicht vorgesehene Sollbruchlinie (7, 8) aneinander anschließen, wobei durch Brechen entlang der Sollbruchlinie (7, 8) eine Vereinzelung von Substratbereichen in Einzelsubstrate vorgesehen ist, **dadurch gekennzeichnet,**
**dass** die wenigstens eine Metallfläche (3', 3", 3"'; 4', 4", 4"') der Substratbereiche an einem einer Sollbruchlinie (7, 8) benachbarten und entlang dieser Sollbruchlinie (7, 8) verlaufenden Rand zumindest eine Randabschwächung (10) in der Form aufweist, dass dort die Menge des die wenigstens eine Metallfläche (3', 3", 3"'; 4', 4", 4"'). bildenden Metalls je Volumeneinheit auf 10 bis 80% reduziert ist, und zwar bezogen auf die spezifische Metallmenge, die die Metallfläche außerhalb der Randabschwächung (10) aufweist, wobei die Breite (a) der Randabschwächung 0,2 bis 6 mm beträgt und wobei die Randabschwächung von Vertiefungen oder Ausnehmungen (12, 13, 14, 16) im Material der Metallfläche gebildet ist.

2. Keramik-Metall-Substrat nach Anspruch 1, **dadurch gekennzeichnet, dass** zumindest an einer Oberflächenseite des Keramik-Metall-Substrates sämtliche, jeweils einer Sollbruchlinie (7, 8) benachbarte Ränder der Metallflächen (3', 3", 3"'; 4', 4", 4"') mit einer Randabschwächung (10) versehen sind.

3. Keramik-Metall-Substrat nach Anspruch 1 oder'2, **dadurch gekennzeichnet, dass** die Metallflächen der Substratbereiche von wenigstens einer strukturierten Metallisierung (3, 4) an wenigstens einer Oberflächenseite der Keramikschicht (2) gebildet sind.

4. Keramik-Metall-Substrat nach einem der Ansprüche 1 - 3, **gekennzeichnet durch** wenigstens eine rechteck- oder streifenförmige Metallfläche (3", 3"'; 4", 4"'), die sich an wenigstens einer Oberflächenseite der Keramikschicht (2) zumindest entlang eines Randes (5, 6) des Keramik-Metall-Substrates erstreckt, sowie durch wenigstens eine Sollbruchlinie (7, 8) zwischen dieser äußeren Metallfläche und benachbarten Substratbereichen, wobei auch die wenigstens eine äußere Metallfläche (3", 3"', 4", 4"') entlang der Sollbruchlinie (7, 8) eine Randabschwächung (10) aufweist.

5. Keramik-Metall-Substrat nach einem der Ansprüche 1 - 4, **dadurch gekennzeichnet, dass** der die Randabschwächung aufweisende Rand einen Randabstand (d1, d2) von der benachbarten Sollbruchlinie (7, 8) oder der Ebene (SE) dieser Sollbruchlinie aufweist, der kleiner als 1 mm ist.

6. Keramik-Metall-Substrat nach einem der Ansprüche 1 bis 5, **dadurch gekennzeichnet, dass** die Vertiefungen oder Ausnehmungen jeweils durchgehend ausgebildet sind, d.h. bis an die der Metallfläche benachbarte Oberflächenseite der Keramikschicht (2) reichen, oder so ausgeführt sind, dass zwischen der der jeweiligen Metallfläche benachbarten Oberflächenseite der Keramikschicht (2) noch Metall der Metallfläche verblieben ist.

7. Keramik-Metall-Substrat nach einem der Ansprüche 1 bis 6, **dadurch gekennzeichnet, dass** die Randabschwächung von einer Vielzahl von lochartigen Vertiefungen (12, 13) gebildet ist, die einen Durchmesser von etwa 0,5 bis 0,6 mm aufweisen.

8. Keramik-Metall-Substrat nach einem der Ansprüche 1 bis 7, **dadurch gekennzeichnet, dass** die Randabschwächung von einer Vielzahl von lochartigen Vertiefungen (12, 13) gebildet ist, die nach Art einer Lochreihe angeordnet sind , und dass die eine einfache Lochreihe bildenden Vertiefungen (12) einen Durchmesser von 0,5 mm aufweisen, und zwar bei einer Breite der Randabschwächung von etwa 0,8 mm und bei einem Abstand des Randes von der Sollbruchlinie von etwa 0,5 mm.

9. Keramik-Metall-Substrat nach einem der Ansprüche 1 bis 7, **dadurch gekennzeichnet, dass** die Randabschwächung von einer Vielzahl von lochartigen Vertiefungen (12, 13) gebildet ist, die nach Art mehrerer Lochreihe (12, 13) angeordnet sind, und dass die Vertiefungen (12, 13) der jeweils außen liegenden Lochreihe einen Durchmesser aufweisen, der größer ist als der Durchmesser der Vertiefungen der inneren Lochreihe.

10. Keramik-Metall-Substrat einem der Ansprüche 1 bis 6, **dadurch gekennzeichnet, dass** die Randabschwächung von einer nutenförmigen Vertiefung (16) oder zumindest in einem Teilbereich von einer Abstufung (15) oder durch eine Abschrägung (11) des betreffenden Randes, beispielsweise durch eine Abschrägung gebildet ist, die mit der Ebene der Keramikschicht (2) einen Winkel kleiner als 45° einschließt.

11. Keramik-Metall-Substrat nach einem der Ansprüche 1 - 10, **dadurch gekennzeichnet, dass** an den Substratbereichen jeweils an beiden Oberflächenseiten der Keramikschicht (2) wenigstens eine Metallfläche (3', 4') vorgesehen ist, und dass die Metallflächen (4') an einer ersten der beiden Oberflächenseiten einen Randabstand (d1) von der benachbarten Sollbruchlinie (7, 8) oder deren Ebene (SE) aufweisen, der kleiner ist als der Randabstand (d2) der Metallflächen (3') an der zweiten der beiden Oberflächenseiten des Keramik-Metall-Substrates.

## Claims

1. Ceramic-metal substrate as a multiple substrate with a ceramic plate or layer (2) which forms at least two adjoining substrate regions which are connected in one piece to one another and which are each provided on at least one surface side of the ceramic layer (2) with at least one metal surface (3', 3", 3"'; 4', 4", 4"') which is created by applying a metal layer or metal foil by means of the DCB or active solder process, and which each adjoin one another via at least one ideal break line (7, 8) which is provided in the ceramic layer, wherein the substrate regions can be separated into individual substrates by breaking along the ideal break line (7, 8), **characterised in that** the at least one metal surface (3', 3", 3"'; 4', 4", 4"') of the substrate regions has at an edge running along the ideal break line (7, 8) and adjoining this ideal break line (7, 8) at least one edge weak spot (10) in a form such that the amount of metal forming the at least one metal surface (3', 3", 3"'; 4', 4", 4"') is reduced per volume unit to 10 to 80%, namely in relation to the specific metal quantity which the metal surface has outside of the edge weak spot (10), wherein the width (a) of the edge weak spot amounts to 0.2 to 6 mm, and wherein the edge weak spot is formed by indentations or recesses (12, 13, 14, 16) in the material of the metal surface.

2. Ceramic-metal substrate according to claim 1 **characterised in that** on at least one surface side of the ceramic-metal substrate all the edges of the metal surfaces (3', 3", 3"'; 4', 4", 4"') each adjoining an ideal break line (7, 8) are provided with an edge weak spot (10).

3. Ceramic-metal substrate according to claim 1 or 2 **characterised in that** the metal surfaces of the substrate regions are formed by at least one structured metal plating (3, 4) on at least one surface side of the ceramic layer (2).

4. Ceramic-metal substrate according to one of claims 1 to 3 **characterised by** at least one rectangular or strip-like metal surface (3", 3"'; 4", 4"') which on at least one surface side of the ceramic layer (2) extends at least along an edge (5, 6) of the ceramic-metal substrate, as well as by at least one ideal break line (7, 8) between this outer metal surface and adjoining substrate regions, wherein the at least one outer metal surface (3", 3"'; 4", 4"') has an edge weak spot (10) along the ideal break line (7, 8).

5. Ceramic-metal substrate according to one of claims 1 to 4 **characterised in that** the edge having the edge weak spot has a marginal spacing (di, d2) from the adjoining ideal break line (7, 8) or the plane (SE) of this ideal break line which is less than 1 mm.

6. Ceramic-metal substrate according to one of claims 1 to 5 **characterised in that** the indentations or recesses are each formed continuous, i.e. extend up to the surface side of the ceramic layer (2) adjoining the metal surface, or are designed so that some metal of the metal surface still remains between the surface side of the ceramic layer (2) adjoining the relevant metal surface.

7. Ceramic-metal substrate according to one of claims 1 to 6 **characterised in that** the edge weak spot is formed by a number of hole-type indentations (12,13) which have a diameter of about 0.5 to 0.6 mm.

8. Ceramic-metal substrate according to one of claims 1 to 7 **characterised in that** the edge weak spot is formed by a number of hole-type indentations (12, 13) which are arranged in the manner of a perforation row, and that the indentations (12) forming a single perforation row have a diameter of 0.5 mm, namely with a width of the edge weak spot of about 0.8 mm and with a distance of the edge from the ideal break line of about 0.5 mm.

9. Ceramic-metal substrate according to one of claims 1 to 7 **characterised in that** the edge weak spot is formed by a number of hole-type indentations (12, 13) which are arranged in the manner of several perforation rows (12, 13), and that the indentations (12, 13) of each outer perforation row have a diameter which is greater than the diameter of the indentations of the inner perforation row.

10. Ceramic-metal substrate according to one of claims 1 to 6 **characterised in that** the edge weak spot is formed by a grooved indentation (16) or at least in one regional part by a step (15) or by an incline (11) of the relevant edge, by way of example by an incline which includes an angle of less than 45° with the plane of the ceramic layer (2).

11. Ceramic-metal substrate according to one of claims 1 to 10 **characterised in that** at the substrate regions on each of the two surface sides of the ceramic layer (2) there is at least one metal surface (3', 4'), and that the metal surfaces (4') on a first of the two surface sides have a marginal spacing (d1) from the adjoining ideal break line (7, 8) or the plane (SE) thereof which is less than the marginal spacing (d2) of the metal surfaces (3') on the second of the two surface sides of the ceramic-metal substrate.

## Revendications

1. Substrat en céramique-métal à titre de substrat mixte comprenant une plaque ou une couche de céramique (2) qui forme au moins deux zones de substrat se raccordant l'une à l'autre et reliées l'une à l'autre en une seule pièce, qui sont munies respectivement sur au moins un côté superficiel de la couche de céramique (2) d'au moins une surface métallique (3', 3", 3"'; 4', 4", 4"') obtenue par application d'une couche métallique ou d'une feuille mince métallique au moyen du procédé DCB ou à brasage actif, et qui se raccordent l'une à l'autre respectivement via au moins une ligne de rupture (7, 8) prévue dons la couche de céramique, une individualisation de zones de substrat en substrats individuels étant prévue par rupture le long de la ligne de rupture (7, 8),**caractérisé en ce que**
ladite au moins une surface métallique (3', 3", 3"'; 4', 4", 4"') des zones de substrat présente, à un bord voisin d'une ligne de rupture (7,8) et s'étendant le long de cette ligne de rupture (7,8), au moins un affaiblissement marginal (10) sous une forme telle que la quantité du métal formant ladite au moins une surface métallique (3', 3", 3"'; 4', 4", 4"') soit réduite de 10 à 80 % par unité de volume, et de ce fait par rapport à la quantité spécifique de métal que présente la surface métallique en dehors de l'affaiblissement marginal (10), la largeur (a) de l'affaiblissement marginal étant comprise entre 0,2 et 6 mm et l'affaiblissement marginal étant formé par des renfoncements ou des évidements (12, 13, 14, 16) dans la matière de la surface métallique.

2. Substrat en céramique-métal selon la revendication 1 **caractérisé en ce que**, au moins sur un côté superficiel du substrat en céramique-métal, les bords des surfaces métalliques (3', 3", 3"' 4', 4", 4"') respectivement voisins d'une ligne de rupture (7, 8) sont munis d'un affaiblissement marginal (10).

3. Substrat en céramique-métal selon la revendication 1 ou 2, **caractérisé en ce que** les surfaces métalliques des zones de substrat sont formées par au moins une métallisation structurée (3, 4) sur au moins un côté superficiel de la couche de céramique (2).

4. Substrat en céramique-métal selon l'une des revendications 1 à 3, **caractérisé par** au moins une surface métallique (3", 3"' ; 4", 4"') de forme rectangulaire ou en forme de bande qui s'étend, sur au moins un côté superficiel de la couche de céramique (2), au moins le long d'un bord (5, 6) du substrat en céramique-métal, ainsi que par au moins une ligne de rupture (7,8) entre cette surface métallique externe et des zones de substrat voisines, ladite au moins une surface métallique externe (3", 3"' ; 4", 4"') le long de la ligne de rupture (7, 8) présentant également un affaiblissement marginal (10).

5. Substrat en céramique-métal selon l'une des revendications 1 à 4, **caractérisé en ce que** le bord présentant l'affaiblissement marginal présente un écart marginal (d1, d2), par rapport à la ligne de rupture voisine (7, 8) ou par rapport au plan (SE) de cette ligne de rupture, qui est inférieur à 1 mm.

6. Substrat en céramique-métal selon l'une des revendications 1 à 5, **caractérisé en ce que** les renfoncements ou les évidements sont réalisés chaque fois en continu, c'est-à-dire jusqu'à atteindre le côté superficiel de la couche de céramique (2) voisin de la surface métallique, ou bien sont réalisés de telle sorte que du métal de la surface métallique subsiste entre les côtés superficiels de la couche de céramique (2) voisins de la surface métallique respective.

7. Substrat en céramique-métal selon l'une des revendication 1 à 6, **caractérisé en ce que** l'affaiblissement marginal est formé par une multitude de renfoncements (12,13) en forme de trous qui présentent un diamètre d'environ 0,5 à 0,6 mm.

8. Substrat en céramique-métal selon l'une des revendications 1 à 7, **caractérisé en ce que** l'affaiblissement marginal est formé par une multitude de renfoncements (12, 13) en forme de trous qui sont disposés de façon à obtenir une série de trous, et **en ce que** les renfoncements (12) formant une simple série de trous présentent un diamètre de 0,5 mm, et de ce fait avec une largeur de l'affaiblissement marginal d'environ 0,8 mm et avec une distance du bord par rapport à la ligne de rupture d'environ 0,5 mm.

9. Substrat en céramique-métal selon l'une des revendications 1 à 7, **caractérisé en ce que** l'affaiblissement marginal est formé por une multitude de renfoncements (12, 13) en forme de trous, qui sont disposés de façon à obtenir plusieurs séries de trous (12, 13), et **en ce que** les renfoncements (12, 13) respectifs de la série de trous située à l'extérieur présentent un diamètre qui est supérieur au diamètre des renfoncements de la série de trous située à l'intérieur.

10. Substrat en céramique-métal selon l'une des revendication 1 à 6, **caractérisé en ce que** l'affaiblissement marginal est formé par un renfoncement (16) en forme de rainure ou, au moins dans une zone partielle, par un gradin (15) ou par un chanfrein (11l) du bord correspondant, par exemple par un chanfrein qui forme avec le plan de la couche de céramique (2) un angle qui est inférieur à 45°.

11. Substrat en céramique-métal selon l'une des revendications 1 à 10, **caractérisé en ce qu'**il est prévu au moins une surface métallique (3', 4') dans les zones de substrat sur les deux côtés superficiels respectifs de la couche de céramique (2), et **en ce que** les surfaces métalliques (4') présentent sur un premier des deux côtés superficiels un écart marginal (d1), par rapport à la ligne de rupture voisine (7, 8) ou par rapport au plan (SE) de cette dernière, qui est inférieur a l'écart marginal (d2) des surfaces métalliques (3') sur le deuxième côté des deux côtés superficiels du substrat en céramique-métal.
